# EUROPÄISCHE PATENTSCHRIFT

(11) **EP 2 168 792 B1**
(45) Veröffentlichungstag und Bekanntmachung des Hinweises auf die Patenterteilung: **06.09.2017**
(21) Anmeldenummer: 09012076.7
(22) Anmeldetag: 23.09.2009
(51) Int. Cl.: B60H 1/00

(54) **System und Verfahren zum Kühlen einer elektronischen Steuereinheit**
System and method for cooling an electronic control unit
Système et méthode pour refroidir une unité de commande électronique

(30) Priorität: 25.09.2008 DE 102008048997
(43) Veröffentlichungstag der Anmeldung: 31.03.2010
(73) Patentinhaber: KNORR-BREMSE Systeme für Nutzfahrzeuge GmbH, 80809 München (DE)
(72) Erfinder: Rebhan, Stephan, 81373 München (DE)
(74) Vertreter: Schönmann, Kurt

(56) Entgegenhaltungen:
- WO-A1-2005/068256
- DE-A1- 19 804 698
- DE-A1-102007 032 852
- GB-A- 2 343 161
- US-A- 5 669 813
- US-A1- 2007 000 231

## Beschreibung

Die Erfindung betrifft ein System zum Kühlen einer elektronischen Steuereinheit eines Kraftfahrzeugs, wobei das System eine Einrichtung zum Entnehmen von Luft aus einem Fahrerhaus oder Frachtraum des Kraftfahrzeugs und zum Zuführen der entnommenen Luft zu der elektronischen Steuereinheit umfasst, wobei das System zum Kühlen eine erste Kühlbetriebsart aufweist, in der Luft, die dem Fahrerhaus bzw. Frachtraum mittels der Einrichtung entnommen und der elektronischen Steuereinheit zugeführt wurde, dem Fahrerhaus bzw. Frachtraum nicht wieder zuführbar ist, wobei die Einrichtung einen Luftkanal aufweist, der ein Gebläse aufweist, wobei die Einrichtung zwischen dem Fahrerhaus und der elektronischen Steuereinheit bzw. zwischen dem Frachtraum und der elektronischen Steuereinheit angeordnet ist. Hier und im Folgenden wird der Begriff "Einrichtung" für eine Vorrichtung verwendet, die auch als Luftzuführungsvorrichtung bezeichnet werden kann.

Weiterhin betrifft die Erfindung ein Verfahren zum Kühlen einer elektronischen Steuereinheit eines Kraftfahrzeugs, wobei einem Fahrerhaus oder Frachtraum des Kraftfahrzeugs Luft entnommen und mittels eines Gebläses der elektronischen Steuereinheit zugeführt wird, wobei in einer ersten Kühlbetriebsart Luft, die dem Fahrerhaus bzw. Frachtraum entnommen und der elektronischen Steuereinheit zugeführt wurde, dem Fahrerhaus bzw. Frachtraum nicht wieder zugeführt wird, wobei die Einrichtung einen Luftkanal aufweist, der ein Gebläse aufweist, wobei die Einrichtung zwischen dem Fahrerhaus und der elektronischen Steuereinheit bzw. zwischen dem Frachtraum und der elektronischen Steuereinheit angeordnet ist.

Außerdem betrifft die Erfindung ein Kraftfahrzeug mit einem gattungsgemäßen System zum Kühlen einer elektronischen Steuereinheit eines Kraftfahrzeugs.

Elektronische Steuereinheiten von Kraftfahrzeugen, insbesondere Steuerelektroniken für Fahrwerk und/oder Antriebsstrang, insbesondere Steuergeräte für Getriebe, sind meist im Fahrerhaus angeordnet. Hierdurch vermeidet man eine unerwünschte Belastung der Steuereinheiten, insbesondere durch hohe Temperaturen, die auftreten können, wenn die Steuereinheiten an anzusteuernden bzw. zu überwachenden Komponenten befestigt sind. Nachteilig an der Unterbringung im Fahrerhaus ist die lange Signalstrecke zwischen Steuereinheit und anzusteuernden bzw. zu überwachenden Komponenten, die teuer, unflexibel und aufgrund der langen Leitungen negative Auswirkungen auf die Regelzeit und die Signalqualität hat. Daher geht bei Steuerelektroniken für Fahrwerk und/oder Antriebsstrang, insbesondere bei Getriebesteuerungen, der Trend hin zu lokal am Fahrwerk bzw. Antriebsstrang montierten Elektroniken.

Im Rahmen der Einführung neuer Generationen von Antriebssträngen, die verschärften Abgasvorschriften, Lärmreduzierung und Emissionsreduzierung nachkommen müssen, ist mit immer höheren Temperaturen am Antriebsstrang zu rechnen. Außerdem steigen die Anforderungen der Hersteller an die Lebensdauer und Ausfallsicherheit der Systeme. Andererseits ist insbesondere die Elektronik einer Steuereinheit bei den im Antriebsstrang stark erhöhten Temperaturen im Grenzbereich des technisch Machbaren angelangt. Daher wird bei Motorsteuerungen des Öfteren auf eine aktive Kühlung zurückgegriffen. Diese Kühlung erfolgt mit Motorkühlwasser, was auf Grund von Temperaturschocks und einer hohen Dauertemperatur ungünstige Auswirkungen haben kann, oder mit Treibstoff. Letzterer steht aber am Getriebe nicht zur Verfügung. Daher müsste für eine an einem Getriebe befestigte Steuereinheit eine aktive Kühlung als separater Kühlkreislauf ausgeführt werden, was sehr aufwändig und teuer wäre.

Die US2007/0000231A1 beschreibt eine Kühlvorrichtung für einen mobilen Elektronikaufbau, der einen Umrichter für einen Antriebsmotor umfasst. Ein Luftkanal führt dem Elektronikaufbau Kühlluft aus einem Fahrgastraum zu, und ein Luftauslass verbindet den Elektronikaufbau mit einem Ansauggebläse.

Die WO2005/068256A1 beschreibt eine Vorrichtung zum Aufbewahren und Warten von elektrischen Geräten auf einem Fahrzeug. Ein Gebläse saugt über einen Luftkanal und einen Lufteinlass Luft an. In dem Luftkanal können elektrische Geräte angeordnet werden, so dass die angesaugte Luft auf dem Weg von dem Lufteinlass zu dem Gebläse an den Geräten vorbeistreicht und die Geräte kühlt.

Die US 5 669 813 A beschreibt eine Vorrichtung zum Kühlen von elektronischen Bauteilen in einem Kraftfahrzeug. Die Vorrichtung umfasst einen Luftkanal zum Zuführen von Luft zu den elektronischen Bauteilen. Die Vorrichtung zum Kühlen weist eine Kühlbetriebsart auf, in der Luft, die den elektronischen Bauteilen zugeführt wurde, in die Umgebung entlassen wird.

Die DE 198 04 698 A1 beschreibt ein Kraftfahrzeug mit einer Klimaanlage zur Klimatisierung eines Fahrerraums. Während die Klimaanlage zumindest teilweise in einem Umluftbetrieb arbeitet, wird ein Umluftanteil, der aus dem Fahrerraum abgezogen wurde, durch einen abgegrenzten Raum geführt, in dem sich zu kühlende Elektronikkomponenten befinden. Danach tritt der Umluftanteil in das Klimagerät ein. Dieses konventionelle System führt im teilweisen und auch im vollständigen Umluftbetrieb zu einem erhöhten Energieverbrauch der Klimaanlage.

Der Erfindung liegt die Aufgabe zugrunde, eine kostengünstige und technisch unproblematisch realisierbare Kühlung für eine elektronische Steuereinheit zur Verfügung zu stellen, welche mit einem höheren Gesamtwirkungsgrad arbeitet.

Diese Aufgabe wird mit den Merkmalen der unabhängigen Ansprüche gelöst.

Vorteilhafte Ausführungsformen der Erfindung sind in den abhängigen Ansprüchen angegeben.

Die Erfindung baut auf dem gattungsgemäßen System dadurch auf, dass die Luft, die der elektronischen Steuereinheit mittels der Einrichtung zuführbar ist, nicht teilweise einem Bereich außerhalb des Fahrerhauses bzw. des Frachtraums des Kraftahrzeugs entnehmbar ist. Abluft, welche nach Durchmischung mit Umgebungsluft in der Umgebung des Kraftfahrzeugs in geringer Konzentration wieder in das Fahrerhaus bzw. den Frachtraum gelangt, wird hierbei im Sinne der vorliegenden Erfindung nicht als "dem Fahrerhaus bzw. Frachtraum wiederzuführbar" angesehen. Die Erfindung vermeidet, dass dem Innenraum eine Luft zugeführt wird, die von der elektronischen Steuereinheit zusätzlich aufgeheizt wurde. Eine solche zusätzliche Aufheizung von Umluft mittels der elektronischen Steuereinheit kann bei hohen Außentemperaturen und ohne Klimabetrieb für Fahrer und Fahrgäste unangenehm sein bzw. für transportierte Fracht schädlich sein. Die zusätzliche Aufheizung könnte zwar mittels einer Erhöhung einer Leistungsfähigkeit der Belüftungs- oder Klimaanlage entgegengewirkt werden. Dies wiederum würde nachteiligerweise eine Erhöhung des Fahrzeuggewichts, der Herstellungskosten und - aufgrund des erhöhten Fahrzeuggewichts und der erhöhten Leistung der Klimaanlage - eine Erhöhung des Kraftstoffverbrauchs nach sich ziehen. Trotz der erfindungsgemäßen Maßnahme (dem Fahrerhaus bzw. Frachtraum keine dem Fahrerhaus bzw. Frachtraum mittels der Luftzuführungsvorrichtung entnommene und der elektronischen Steuereinheit zugeführte Luft zuzuführen) bleibt das vorteilhafte Merkmal des gattungsgemäßen Systems gewahrt, das darin besteht, dass zur Temperierung der elektronischen Steuereinheit bereits temperierte Luft aus dem Fahrerhaus bzw. Frachtraum genutzt wird. Komplementäre Überlegungen gelten für einen Winterbetrieb, in welchem sowohl der Fahrerraum bzw. Frachtraum als auch die elektronische Steuereinheit zu beheizen ist. Unabhängig davon kann es in einer zweiten Kühlbetriebsart des Systems zum Kühlen der elektronischen Steuereinheit bei mittleren Temperaturen zweckmäßig sein, das Fahrerhaus bzw. den Frachtraum mittels Abwärme aus der elektronischen Steuereinheit zu beheizen. Mit dem erfindungsgemäßen System kann eine räumliche Nähe eines Fahrerhauses in Cap-Over-Ausführung genutzt werden, wie sie insbesondere im Nutzfahrzeugbereich verbreitet ist. Die Temperierung der elektronischen Steuereinheit mit Luft kann als offener Kreislauf ausgeführt werden. Es gibt daher keine besonderen Anforderungen an die Dichtigkeit des Systems, wodurch die Luftkühlung deutlich kostengünstiger als jede Art von Flüssigkeitskühlung ausführbar ist. Ferner kann Luft unproblematisch mit einer für die Kühlung von Elektroniken geeigneten Temperatur zur Verfügung gestellt werden.

Die elektronische Steuereinheit kann einem Fahrwerkstrang oder einem Antriebsstrang des Kraftfahrzeugs zugeordnet sein. Hierdurch ist eine Länge von Signalstrecken zwischen Steuereinheit und anzusteuernden bzw. zu überwachenden Komponenten minimierbar.

Nützlicherweise kann vorgesehen sein, dass die elektronische Steuereinheit einem Getriebe zugeordnet ist. Im Bereich des Getriebes steht normalerweise kein Treibstoff zur Verfügung, welcher zur Flüssigkeitskühlung verwendet werden könnte. Insofern entfaltet die Erfindung ihre besonderen Vorzüge im Hinblick auf eine Getriebekühlung.

Von besonderem Vorteil ist, wenn die Luft einem hinteren Bereich des Fahrerhauses bzw. Frachtraums des Kraftfahrzeugs entnehmbar ist. Der hintere Bereich des Fahrerhauses bzw. Frachtraums enthält ohnehin Entlüftungen, welche ein druckneutrales Zuführen von Umgebungsluft im vorderen Bereich des Fahrerhauses bzw. Frachtraums ermöglichen. Die Entnahme von Luft aus dem hinteren Bereich ist daher besonders ökonomisch, denn die ohnehin vorhandenen Entlüftungsöffnungen können im Rahmen der Luftführungseinrichtung verwendet werden. Außerdem sind hier Luftkanäle zum Getriebe kostengünstig so anschließbar, dass der Fahrer nicht durch Geräusche, insbesondere Getriebegeräusche, belästigt wird.

Eine nicht unter den Schutzbereich der vorliegenden Erfindung fallende Alternative sieht vor, dass der elektronischen Steuereinheit zugeführte Luft teilweise einem Bereich außerhalb eines Fahrerhauses bzw. Frachtraums des Kraftfahrzeugs entnehmbar ist. Durch die Verwendung einer solchen Mischluft können dem Kühlmedium variable Eigenschaften vermittelt werden, nämlich insbesondere im Hinblick auf die Temperatur und den Feuchtigkeitsgehalt der Luft.

Nützlicherweise kann vorgesehen sein, dass die Einrichtung einen Luftkanal aufweist. Ein solcher Luftkanal verbindet dann beispielsweise den Innenbereich des Fahrerhauses bzw. Frachtraums mit der zu kühlenden Elektronik, wobei er bis in den Innenbereich des Fahrerhauses bzw. Frachtraums geführt sein kann, oder er ist außerhalb des Fahrerhauses bzw. Frachtraums an Entlüftungsöffnungen angeschlossen.

Das System kann einen Temperatursensor zur Erfassung einer Temperatur der elektronischen Steuereinheit sowie eine Auswertungsvorrichtung umfassen, mittels derer eine Berechnung einer Lebensdauererwartung der elektronischen Steuereinheit in Abhängigkeit der Temperatur durchführbar ist, die mittels des Temperatursensors erfassbar ist. Hierdurch kann ein Material- und Wartungsaufwand vermieden werden, der sonst durch vorzeitigen Austausch verursacht wird.

Von besonderem Vorteil ist, dass die Einrichtung ein Gebläse aufweist. Die Luft kann also aktiv der elektronischen Steuereinheit zugewiesen werden. Ebenfalls ist eine passive Zuführung ohne Gebläse möglich. Zur aktiven Zuweisung der Luft kann auch die Gebläseleistung eines heutzutage immer vorhandenen Gebläses "Fahrzeuggebläse-Innenraum" genutzt werden, insbesondere wenn der Abluftstrom des Fahrerhauses vollständig oder fast vollständig der Einrichtung zugeführt wird.

Es kann zweckmäßig sein, wenn eine Kühlleistung der Einrichtung bei nicht angetriebenem Gebläse zumindest vorübergehend für einen zuverlässigen Betrieb der elektronischen Steuereinheit ausreicht, wobei ein Betrieb des Gebläses eine Lebensdauererwartung der elektronischen Steuereinheit verlängert. Hierdurch ist ein gefahrloser Notbetrieb bis zum Austausch des Gebläses möglich.

Insbesondere ist es von Vorteil, wenn die Auswertungsvorrichtung bei einer Betriebsstörung des Gebläses oder bei Überschreiten eines Schwellenwertes einer Temperatur der elektronischen Steuereinheit, die von einem Temperatursensor erfasst wird, eine Servicenachricht ausgeben kann. Mittels einer solchen Servicenachricht kann ein Austausch des Gebläses veranlasst und vorbereitet werden.

Außerdem ist es vorteilhaft, wenn die Einrichtung einen Luftsammler zum Zuführen eines ersten Luftstroms zur elektronischen Steuereinheit umfasst, der aufgrund einer Fahrbewegung des Kraftfahrzeugs entsteht.

Die Einrichtung kann eine Vorrichtung zum Zuführen eines zweiten Luftstroms zur elektronischen Steuereinheit umfassen, der mittels eines Gebläses zur Belüftung eines Innenraums des Fahrerhauses bzw. Frachtraums entsteht. Hierdurch kann die Steuereinheit auch dann zwangsgekühlt werden, wenn ein Gebläse der Einrichtung ausgefallen ist oder eingespart wurde.

Es ist nützlich, wenn die Einrichtung eine Filtereinheit aufweist. Hierdurch wird eine Kontamination der elektronischen Steuereinheit vermieden.

Es kann ebenfalls vorgesehen sein, dass die Einrichtung eine Sperrklappe aufweist. Der Kühlluftstrom kann auf diese Weise unterbrochen und/oder umgeleitet werden, so dass beispielsweise dann, wenn keine geeignet klimatisierte Luft zur Verfügung steht, insbesondere kurzfristig auf eine Klimatisierung verzichtet werden kann.

Die Erfindung ist gemäß einer besonders bevorzugten Ausführungsform dadurch weiterentwickelt, dass mindestens eine Komponente der Einrichtung durch die elektronische Steuereinheit beeinflussbar ist. Eine solche Beeinflussung kann in einer Steuerung oder auch in einer Regelung bestehen. Dies kann auf der Grundlage einer im Bereich der elektronischen Steuereinheit erfassten Temperatur erfolgen. Ist beispielsweise die Temperatur der elektronischen Steuereinheit zugeführten Luft ungünstig, so kann die elektronische Steuereinheit ein Verschließen einer Sperrklappe bewirken. Die Sperrklappe kann nach einer vorgegebenen Zeit oder aufgrund anderer Anlässe wieder geöffnet werden, so dass dann erneut geprüft werden kann, ob zur Klimatisierung geeignete Luft durch die Einrichtung zur Verfügung gestellt wird. Aber auch die Drehzahl des Gebläses oder sonstige Eigenschaften der Einrichtung können durch die Steuereinheit im Rahmen einer Regelung und/oder Steuerung beeinflusst werden.

Es kann von Vorteil sein, dass der Luftkanal über eine flexible Manschette mit der elektronischen Steuereinheit gekoppelt ist. Die flexible Manschette ermöglicht eine gezielte und effiziente Zuführung von Klimatisierungsluft, ihre Flexibilität entkoppelt die Einrichtung von der Steuereinheit gegen Schwingungen, die beispielsweise durch das Gebläse auf die Einrichtung übertragen werden können, aufgrund der Schwingungsentkopplung aber nicht oder nur in verringertem Maße auf die elektronische Steuereinheit.

Ebenfalls ist es denkbar, dass der Luftkanal keine mechanische Verbindung zu der elektronischen Steuereinheit aufweist. Die elektronische Steuerung wird also offen angeblasen.

Es kann vorgesehen sein, dass der Luftkanal mindestens eine Leckage aufweist. Eine solche Leckage kann beabsichtigt sein, um das Strömungsverhalten der Klimatisierungsluft zu verändern. Aber auch Leckagen, die aufgrund einer Beschädigung der Klimatisierungseinrichtung bestehen, sind im Rahmen der vorliegenden Erfindung tragbar, was nicht der Fall wäre, wenn mit einem flüssigen Kühlmedium gekühlt würde.

Das System zum Kühlen der elektronischen Steuereinheit kann eine zweite Kühlbetriebsart aufweisen, in der das Fahrerhaus bzw. der Frachtraum mittels Abwärme aus der elektronischen Steuereinheit beheizbar ist. Durch Verwendung der von der Wärmequelle oder von der elektronischen Steuereinheit abgegebenen Wärme kann eine Energie, die sonst zur Beheizung des Fahrzeuginnenraums bereitgestellt werden müsste, eingespart oder einer anderen Verwendung zugeführt werden.

Die Erfindung baut auf dem gattungsgemäßen Verfahren dadurch auf, dass die Luft, die der elektronischen Steuereinheit mittels der Einrichtung zuführbar ist, nicht teilweise einem Bereich außerhalb des Fahrerhauses bzw. des Frachtraums des Kraftfahrzeugs entnehmbar ist. Hierdurch werden die Vorteile und Besonderheiten des erfindungsgemäßen Systems auch im Rahmen eines Verfahrens realisiert.

Weiterhin kann vorgesehen sein, dass die Luft einem hinteren Bereich des Fahrerhauses bzw. Frachtraum des Kraftfahrzeugs entnommen wird.

Eine nicht unter den Schutzbereich der vorliegenden Erfindung fallende Alternative sieht vor, dass der elektronischen Steuereinheit zugeführte Luft teilweise einem Bereich außerhalb eines Fahrerhauses bzw. Frachtraums des Kraftfahrzeugs entnommen wird.

Das erfindungsgemäße Verfahren ist in besonders vorteilhafter Weise dadurch weitergebildet, wenn das Zuführen von Luft durch die elektronische Steuereinheit beeinflusst wird.

In einer zweiten Kühlbetriebsart zum Kühlen der elektronischen Steuereinheit kann das Fahrerhaus bzw. der Frachtraum mittels Abwärme aus der elektronischen Steuereinheit beheizt werden.

Die Erfindung baut auf dem gattungsgemäßen Kraftfahrzeug dadurch auf, dass das Kraftfahrzeug ein erfindungsgemäßes System zum Kühlen einer elektronischen Steuereinheit umfasst.

Die Luft aus dem Fahrerhaus ist klimatisiert und daher besonders für Kühlzwecke geeignet. Während die Luft im Sommer gekühlt ist, ist sie im Winter in der Regel geheizt, so dass die zu kühlende elektronische Steuereinheit nicht mit kalter und damit frostgefährdeter Luft angeblasen wird. Damit können Getriebeelektroniken die geforderten Lebensdauern gut erreichen. Luft als Kühlmedium ist unproblematisch zu handhaben und kann insbesondere mit geeigneter Temperatur und aufgrund der Klimatisierung im Fahrerhaus bzw. Frachtraum getrocknet zur Verfügung gestellt werden. Herkömmlicherweise sind Getriebe in der Nähe des Fahrerhauses, insbesondere unterhalb, angeordnet, so dass eine Zuführung von Luft, die dem Fahrerhaus entnommenen wurde, zu einer Getriebeelektronik, die in einem Bereich des Getriebes befestigt ist, besonders unproblematisch ist. Das erfindungsgemäße System zum Kühlen einer elektronischen Steuereinheit ermöglicht eine kostenoptimierte Nutzung der baulichen Gegebenheiten von Nutzfahrzeugen mit Fahrerhaus in Cap-Over-Ausführung. So kann auch für eine elektronische Steuereinheit eine geführte Zwangskühlung mit Luft vorgesehen werden, wobei diese Luft nicht als Getriebemedium verwendet wird und die elektronische Steuereinheit nicht zu einer Klimaanlage gehört.

Die Erfindung wird nun mit Bezug auf die begleitenden Zeichnungen anhand bevorzugter Ausführungsformen beispielhaft erläutert

Dabei zeigt:
- Figur 1: eine seitliche Schnittansicht eines Nutzfahrzeugs mit einem erfindungsgemäßen System und
- Figur 2: einen Schnitt senkrecht zur Fahrzeugachse mit einem alternativen System, das nicht unter den Schutzbereich der vorliegenden Erfindung fällt.

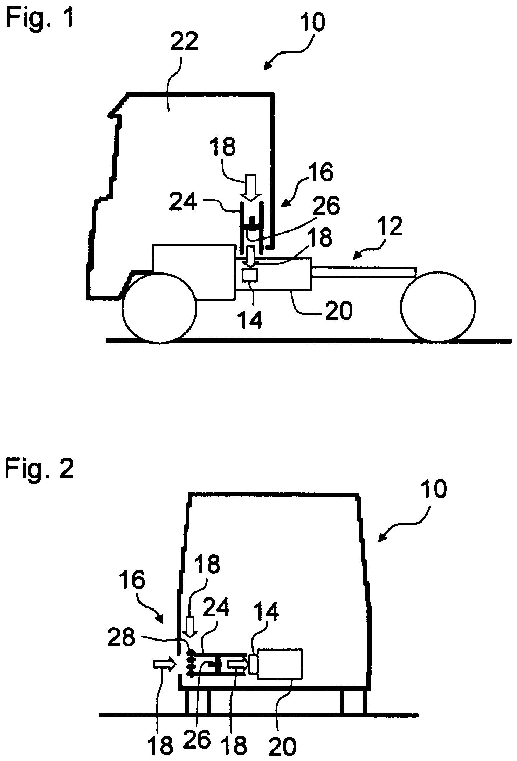

Figur 1 zeigt eine seitliche Schnittansicht eines Nutzfahrzeugs 10 mit einem erfindungsgemäßen System, und Figur 2 zeigt einen Schnitt senkrecht zur Fahrzeugachse mit einer weiteren Ausführungsform eines erfindungsgemäßen Systems. Es ist schematisch ein Teil eines Nutzfahrzeugs 10 mit einem Antriebsstrang 12 dargestellt. Dieser Antriebsstrang 12 umfasst ein Getriebe 20, welches durch eine elektronische Steuereinheit 14 zu steuern ist. Um die elektronische Steuereinheit 14 zu kühlen, ist eine Einrichtung 16 vorgesehen, die einen Luftkanal 24 mit einem Gebläse 26 aufweist. Über den Luftkanal 24 wird dem Innenraum des Fahrerhauses 22 entnommene Luft 18 zu Kühlzwecken der Steuereinheit 14 zugeführt. In der nicht unter den Schutzbereich der vorliegenden Erfindung fallenden Alternative gemäß Figur 2 wird die zur Kühlung verwendete Luft 18 auch teilweise der Umgebung entnommen. Die Luft 18 wird zunächst über eine Filtereinheit 28 geleitet und dann durch den Luftkanal 24 zur elektronischen Steuereinheit 14.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein.

## Patentansprüche

1. System zum Kühlen einer elektronischen Steuereinheit (14) eines Kraftfahrzeugs (10), wobei das System eine Einrichtung (16) zum Entnehmen von Luft (18) aus einem Fahrerhaus (22) oder Frachtraum des Kraftfahrzeugs (10) und zum Zuführen der entnommenen Luft (18) zu der elektronischen Steuereinheit (14) umfasst, wobei das System zum Kühlen eine erste Kühlbetriebsart aufweist, in der Luft (18), die dem Fahrerhaus (22) bzw. Frachtraum mittels der Einrichtung (16) entnommen und der elektronischen Steuereinheit (14) zugeführt wurde, dem Fahrerhaus (22) bzw. Frachtraum nicht wieder zuführbar ist, wobei die Einrichtung (16) einen Luftkanal (24) aufweist, der ein Gebläse (26) aufweist, wobei die Einrichtung (16) zwischen dem Fahrerhaus (22) und der elektronischen Steuereinheit (14) bzw. zwischen dem Frachtraum und der elektronischen Steuereinheit (14) angeordnet ist, **dadurch gekennzeichnet, dass** die Luft (18), die der elektronischen Steuereinheit (14) mittels der Einrichtung (16) zuführbar ist, nicht teilweise einem Bereich außerhalb des Fahrerhauses (22) bzw. des Frachtraums des Kraftfahrzeugs (10) entnehmbar ist.

2. System nach Anspruch 1, **dadurch gekennzeichnet, dass** die elektronische Steuereinheit (14) einem Fahrwerkstrang oder einem Antriebsstrang (12) des Kraftfahrzeugs (10) zugeordnet ist.

3. System nach Anspruch 1 oder 2, **dadurch gekennzeichnet, dass** die elektronische Steuereinheit (14) einem Getriebe (20) zugeordnet ist.

4. System nach einem der Ansprüche 1 bis 3, **dadurch gekennzeichnet, dass** die Luft (18) einem hinteren Bereich des Fahrerhauses (22) bzw. Frachtraums des Kraftfahrzeugs (10) entnehmbar ist.

5. System nach einem der vorhergehenden Ansprüche, **dadurch gekennzeichnet, dass** das System einen Temperatursensor zur Erfassung einer Temperatur der elektronischen Steuereinheit (14) sowie eine Auswertungsvorrichtung umfasst, mittels derer eine Berechnung einer Lebensdauererwartung der elektronischen Steuereinheit (14) in Abhängigkeit der Temperatur durchführbar ist, die mittels des Temperatursensors erfassbar ist.

6. System nach Anspruch 5, **dadurch gekennzeichnet, dass** das Gebläse (26) die Auswertevorrichtung umfasst.

7. System nach einem der vorhergehenden Ansprüche, **dadurch gekennzeichnet, dass** eine Kühlleistung der Einrichtung (16) bei nicht angetriebenem Gebläse (26) zumindest vorübergehend für einen zuverlässigen Betrieb der elektronischen Steuereinheit (14) ausreicht, wobei ein Betrieb des Gebläses (26) eine Lebensdauererwartung der elektronischen Steuereinheit (14) verlängert.

8. System nach Anspruch 7, **dadurch gekennzeichnet, dass** die Auswertungsvorrichtung bei einer Betriebsstörung des Gebläses (26) oder bei Überschreiten eines Schwellenwertes einer Temperatur der elektronischen Steuereinheit (14), die von einem Temperatursensor erfasst wird, eine Servicenachricht ausgeben kann.

9. Verfahren zum Kühlen einer elektronischen Steuereinheit (14) eines Kraftfahrzeugs (10), wobei einem Fahrerhaus (22) oder einem Frachtraum des Kraftfahrzeugs (10) Luft (18) entnommen und mittels eines Gebläses (26) der elektronischen Steuereinheit (14) zugeführt wird, wobei in einer ersten Kühlbetriebsart Luft (18), die dem Fahrerhaus (22) bzw. Frachtraum entnommen und der elektronischen Steuereinheit (14) zugeführt wurde, dem Fahrerhaus (22) bzw. Frachtraum nicht wieder zugeführt wird, wobei die Einrichtung (16) einen Luftkanal (24) aufweist, der ein Gebläse (26) aufweist, wobei die Einrichtung (16) zwischen dem Fahrerhaus (22) und der elektronischen Steuereinheit (14) bzw. zwischen dem Frachtraum und der elektronischen Steuereinheit (14) angeordnet ist, **dadurch gekennzeichnet, dass** die Luft (18), die der elektronischen Steuereinheit (14) mittels der Einrichtung (16) zuführbar ist, nicht teilweise einem Bereich außerhalb des Fahrerhauses (22) bzw. des Frachtraums des Kraftfahrzeugs (10) entnehmbar ist.

10. Verfahren nach Anspruch 9, **dadurch gekennzeichnet, dass** die Luft (18) einem hinteren Bereich des Fahrerhauses (22) bzw. Frachtraums des Kraftfahrzeugs (10) entnommen wird.

11. Verfahren nach Anspruch 9 oder 10, **dadurch gekennzeichnet, dass** das Zuführen von Luft (18) durch die elektronische Steuereinheit (14) beeinflusst wird.

12. Verfahren nach einem der Ansprüche 9 bis 11, **dadurch gekennzeichnet, dass** in einer zweiten Kühlbetriebsart zum Kühlen der elektronischen Steuereinheit (14) das Fahrerhaus (22) bzw. der Frachtraum mittels Abwärme aus der elektronischen Steuereinheit (14) beheizt wird.

## Claims

1. System for cooling an electronic control unit (14) of a motor vehicle (10), wherein the system comprises a means (16) for extracting air (18) from a driver's cab (22) or cargo space of the motor vehicle (10) and feeding the air (18) that has been extracted to the electronic control unit (14), wherein the system for cooling has a first cooling operating mode, in which air (18) that has been extracted from the driver's cab (22) or cargo space through the means (16) and fed to the electronic control unit (14) cannot be fed back to the driver's cab (22) or cargo space, wherein the means (16) has an air duct (24), which has a blower (26), wherein the means (16) is disposed between the driver's cab (22) and the electronic control unit (14) or between the cargo space and the electronic control unit (14), **characterised in that** the air (18) that can be fed to the electronic control unit (14) through the means (16) cannot be partially extracted from an area outside of the driver's cab (22) or the cargo space of the motor vehicle (10).

2. System according to claim 1, **characterised in that** the electronic control unit (14) is assigned to a chassis leg or a drivetrain (12) of the motor vehicle (10).

3. System according to claim 1 or 2, **characterised in that** the electronic control unit (14) is assigned to a transmission (20).

4. System according to one of claims 1 to 3, **characterised in that** the air (18) can be extracted from a rear area of the driver's cab (22) or cargo space of the motor vehicle (10).

5. System according to one of the preceding claims, **characterised in that** the system comprises a temperature sensor for detecting a temperature of the electronic control unit (14) and also an evaluation device, by means of which a calculation of an expected service life of the electronic control unit (14) can be carried out as a function of the temperature, which can be detected by means of the temperature sensor.

6. System according to claim 5, **characterised in that** the blower (26) includes the evaluation device.

7. System according to one of the preceding claims, **characterised in that** a cooling output of the means (16), when the blower (26) is not driven, at least temporarily suffices for a reliable operation of the electronic control unit (14), wherein an operation of the blower (26) extends an expected service life of the electronic control unit (14).

8. System according to claim 7, **characterised in that**, in the event of operational failure of the blower (26) or in the event of exceeding a temperature threshold of the electronic control unit (14), which is detected by a temperature sensor, the evaluation device can output a service message.

9. Method for cooling an electronic control unit (14) of a motor vehicle (10), wherein air (18) is extracted from a driver's cab (22) or a cargo space of the motor vehicle (10) and is fed by means of a blower (26) to the electronic control unit (14), wherein, in a first cooling operating mode, air (18) that has been extracted from the driver's cab (22) or cargo space and fed to the electronic control unit (14) cannot be fed back to the driver's cab (22) or cargo space, wherein the means (16) has an air duct (24), which has a blower (26), wherein the means (16) is disposed between the driver's cab (22) and the electronic control unit (14) or between the cargo space and the electronic control unit (14), **characterised in that** the air (18) that can be fed to the electronic control unit (14) through the means (16) cannot be partially extracted from an area outside of the driver's cab (22) or the cargo space of the motor vehicle (10).

10. Method according to claim 9, **characterised in that** the air (18) is extracted from a rear area of the driver's cab (22) or cargo space of the motor vehicle (10).

11. Method according to claim 9 or 10, **characterised in that** the supply of air (18) is influenced by the electronic control unit (14).

12. Method according to one of claims 9 to 11, **characterised in that**, in a second cooling operating mode for cooling the electronic control unit (14), the driver's cab (22) or the cargo space is heated by means of waste heat from the electronic control unit (14).

## Revendications

1. Système de refroidissement d'une unité (14) électronique de commande d'un véhicule (10) automobile, le système comprenant un dispositif (16) de prélèvement d'air (18) d'une cabine (22) de conducteur ou d'un espace pour la cargaison du véhicule (10) automobile et d'envoi de l'air (18) prélevé à l'unité (14) électronique de commande, le système ayant, pour le refroidissement, un premier type de fonctionnement en refroidissement, dans lequel de l'air (18), qui a été prélevé de la cabine (22) du conducteur et de l'espace pour la cargaison au moyen du dispositif (16) et qui a été envoyé à l'unité (14) électronique de commande, n'est pas retourné à la cabine (22) du conducteur ou à l'espace pour la cargaison, le dispositif (16) ayant un conduit (24) pour de l'air, qui a une soufflante (26), le dispositif (16) étant disposé entre la cabine (22) du conducteur et l'unité (14) électronique de commande ou entre l'espace pour la cargaison et l'unité (14) électronique de commande, **caractérisé en ce que** l'air (18), qui peut être envoyé à l'unité (14) électronique de commande au moyen du dispositif (16), ne peut pas être prélevé en partie, d'une région à l'extérieur de la cabine (22) du conducteur ou de l'espace pour la cargaison du véhicule (10) automobile.

2. Système suivant la revendication 1, **caractérisé en ce que** l'unité (14) électronique de commande est associée à une chaîne de châssis ou à une chaîne (12) d'entraînement du véhicule (10) automobile.

3. Système suivant la revendication 1 ou 2, **caractérisé en ce que** l'unité (14) électronique de commande est associée à une transmission (20).

4. Système suivant l'une des revendications 1 à 3, **caractérisé en ce que** l'air (18) peut être prélevé d'une région arrière de la cabine (22) du conducteur ou de l'espace pour la cargaison du véhicule (10) automobile.

5. système suivant l'une des revendications précédentes, **caractérisé en ce que** le système comprend une sonde de température pour détecter une température de l'unité (14) électronique de commande, ainsi qu'un dispositif d'exploitation, au moyen duquel un calcul d'une espérance de durée de vie de l'unité (14) électronique de commande peut être effectué en fonction de la température, qui peut être détectée au moyen de la sonde de température.

6. Système suivant la revendication 5, **caractérisé en ce que** la soufflante (26) comprend le dispositif d'exploitation.

7. Système suivant l'une des revendications précédentes, **caractérisé en ce qu'**une puissance de refroidissement du dispositif (16) suffit, lorsque la soufflante (26) n'est pas entraînée, au moins transitoirement, pour un fonctionnement fiable de l'unité (14) électronique de commande, un fonctionnement de la soufflante (26) prolongeant une espérance de durée de vie de l'unité (14) électronique de commande.

8. Système suivant la revendication 7, **caractérisé en ce que** le dispositif d'exploitation peut, lorsqu' est dépassée une valeur de seuil d'une température de l'unité (14) électronique de commande détectée par une sonde de température, émettre un message de service.

9. Procédé de refroidissement d'une unité (14) électronique de commande d'un véhicule (10) automobile, dans lequel on prélève de l'air (18) d'une cabine (22) de conducteur ou d'un espace pour la cargaison du véhicule (10) automobile et, au moyen d'une soufflante (26), on l'envoie à l'unité (14) électronique de commande, dans lequel, dans un premier type de fonctionnement en refroidissement, on ne renvoie pas à la cabine (22) du conducteur ou à l'espace pour la cargaison, de l'air (18), qui a été prélevé de la cabine (22) du conducteur ou de l'espace pour la cargaison et qui a été envoyé à l'unité (14) électronique de commande, le dispositif (16) ayant un conduit (24) pour de l'air, qui a une soufflante (26), le dispositif (16) étant disposé entre la cabine (22) du conducteur et l'unité (14) électronique de commande ou entre l'espace pour la cargaison et l'unité (14) électronique de commande, **caractérisé en ce que** l'air, qui peut être envoyé à l'unité (14) électronique de commande au moyen du dispositif (16), ne peut pas être prélevé en partie, d'une région à l'extérieur de la cabine (22) du conducteur ou de l'espace pour la cargaison du véhicule (10) automobile.

10. Procédé suivant la revendication 9, **caractérisé en ce que** l'on prélève l'air (18) d'une région arrière de la cabine (22) du conducteur ou de l'espace pour la cargaison du véhicule (10) automobile.

11. Procédé suivant la revendication 9 ou 10, **caractérisé en ce que** l'envoi de l'air (18) est influencé par l'unité (14) électronique de commande.

12. Procédé suivant l'une des revendications 9 à 11, **caractérisé en ce que** dans un deuxième type de fonctionnement en refroidissement, pour refroidir l'unité (14) électronique de commande, on chauffe la cabine (22) du conducteur ou l'espace pour la cargaison au moyen de la chaleur perdue provenant de l'unité (14) électronique de commande.
